# EUROPEAN PATENT APPLICATION

(11) **EP 1 840 957 A1**
(43) Date of publication of application: **03.10.2007**
(21) Application number: 07006289.8
(22) Date of filing: 27.03.2007
(51) Int. Cl.: H01L 21/762

(54) **Method of producing simox wafer**

(30) Priority: 27.03.2006 JP 2006085340
(71) Applicant: SUMCO Corporation, Tokyo 105-8634 (JP)
(72) Inventor: Nakai, Tetsuya, c/o Sumco Corporation, Tokyo 105-8634 (JP); Murakami, Yoshio, c/o Sumco Corporation, Tokyo 105-8634 (JP)
(74) Representative: Röthinger, Rainer

(57) **Abstract**

A SIMOX wafer is produced at an oxygen ion implantation Step and a high-temperature annealing step, wherein an oxide film is formed on a surface of a wafer prior to the oxygen ion implantation and then the oxygen ion implantation is conducted through the oxide film.

## Description

### BACKGROUND OF THE INVENTION

### 1. Field of the Invention

This invention relates to a thin film SOI wafer having a buried oxide (BOX) film for forming a high-speed, a low power consumption SOI (silicon on insulator) device, and more particularly to a method of producing SIMOX (separation by implanted oxygen) wafer wherein a buried oxide film is formed by implanting an oxygen ion into a wafer surface and annealing at a high temperature.

### 2. Description of the Related Art

As a method of producing a thin film SOI wafer, there have hitherto been known a so-called high-dose SIMOX method wherein a dose in the oxygen implantation is high, and a so-called low-dose SIMOX method wherein an oxygen ion is implanted at a dose lower by about one significant digit than that of the high-dose SIMOX method and then the annealing is carried out in a high oxygen atmosphere.

As the low-dose SIMOX method is recently developed a so-called MLD (modified low dose) method wherein the formation of BOX at a lower dose is made possible by conducting a final oxygen implantation at a lower dose and about room temperature to form an amorphous layer, which contributes to the mass production of wafers.

The high-dose SIMOX method is a method wherein an oxygen ion is implanted under conditions of an acceleration energy: 150 keV, a dose: more than 1.5x10¹⁸ cm⁻² and a substrate temperature: about 500°C and thereafter the annealing is carried out at a temperature of higher than 1300°C in argon (Ar) or nitrogen (N₂) atmosphere containing 0.5-2% of oxygen for about 4-8 hours (see K Izumi et al., Electron lett. (UK) vol. 14, (1978), p.593). However, the high-dose SIMOX method have problems that the implantation time is very long and the throughput is bad and the dislocation density of SOI layer is as very high as 1x10⁵-1x10⁷ cm⁻².

The low-dose SIMOX method improves the above problems of the high-dose SIMOX method, and is typically carried out by implanting an oxygen ion under conditions of an acceleration energy: more than 150 keV, a dose: 4x10¹⁷-1x10¹⁸ cm⁻² and a substrate temperature: about 400-600°C and thereafter conducting the annealing at a temperature of higher than 1300°C in an argon atmosphere containing 30-60% of oxygen, whereby there is attained a significant quality improvement that the buried oxide film (BOX) is thickened by an internal thermal oxidation (which may be abbreviated as "ITOX") at the annealing step and the dislocation density is reduced and the like (see S. Nakashima et al., Proc. IEEE int. SOI Conf. (1994), p71-72).

Further, the MLD method is developed as an improved version of the low-dose SIMOX method, and is a method wherein after the existing oxygen implantation at a high temperature (400-650°C), a further oxygen implantation of a dose lower by one significant digit is carried out at room temperature to form an amorphous layer on the surface of the buried oxide film (BOX) (see O. W. Holland et al., Appl. Phys. Lett. (USA) vol. 69 (1996), p574 and U.S. Patent No. 5930643). According to this method, it is possible to conduct the continuous growth of BOX within a wide and low dose range of 1.5x10¹⁷-6x10¹⁷ cm⁻², and also even in the subsequent ITOX process, the internal thermal oxidation may be conducted at a rate higher by 1.5 times than that of the conventional ITOX. As a result, the BOX film is very near to the thermal oxide film, and a significant quality improvement is attained. In the MLD method, it is common that the annealing is carried out in an Ar atmosphere containing 0.5-2% of oxygen for about 5-10 hours after the ITOX step in order to decrease an oxygen content in SOl layer.

As mentioned above, in all of the high-dose SIMOX method, low-dose SIMOX method and MLD method, the SIMOX process roughly consists of an implantation step of implanting the oxygen ion at an energy of about 150 keV or more and at a dose of about 1.5x10¹⁷-1x10¹⁸ cm⁻² and a high-temperate annealing step of bringing back the damage produced by the implanted oxygen ion to form a flat buried oxide film (BOX). In such SIMOX process, the oxygen ion is implanted into a bare silicon wafer (having no oxide film or the like) and the bare silicon is annealed at a high temperature to form the buried oxide film (BOX).

In the SIMOX process, however, it is known that many particles are adhered onto the silicon surface at the implantation step under conditions of a relatively high temperature (350-500°C) and a high dose (2x10¹⁷-1x10¹⁸ cm⁻²) to cause a surface defect. Even at the high-temperature annealing step for forming the buried oxide film (BOX) after the oxygen ion implantation, particles are generated from members such as tube, boat, holder and the like to adhere onto the bare silicon, which is also confirmed to cause the surface defect.

### SUMMARY OF THE INVENTION

It is, therefore, an object of the invention to advantageously solve the aforementioned problems and to propose a method of producing SIMOX wafer in which the adhesion of particles onto the silicon surface is effectively suppressed not only at the oxygen ion implantation step but also at the high-temperature annealing step to largely reduce the occurrence of surface defect resulted from these particles as compared with the conventional techniques.

The inventors have made various studies in order to achieve the above object and discovered that an oxide film is formed on the surface of the wafer at a proper thickness prior to the oxygen ion implantation and then the oxygen ion implantation is conducted through this oxide film, whereby the direct contact of the particles adhered to the wafer at this step with the silicon surface can be prevented effectively, and also the oxide film is used as a protection film as the subsequent high-temperature annealing step without removing after the oxygen ion implantation, whereby the direct contact of the particles with the silicon surface can also be prevented.

The invention is based on the above knowledge and the construction thereof is as follows.
(1) A method of producing a SIMOX wafer comprising an oxygen ion implantation step and a high-temperature annealing step, wherein an oxide film is formed on a surface of a wafer prior to the oxygen ion implantation and then the oxygen ion implantation is conducted through the oxide film.

(2) A method of producing a SIMOX wafer according to item (1), wherein a part or a whole of the oxide film is etched to remove particles adhered onto the oxide film after the oxygen ion implantation.

(3) A method of producing a SIMOX wafer according to item (1), wherein at least a part of the oxide film after the oxygen ion implantation is utilized as a protection film at the subsequent high-temperature annealing step without complete removal.

(4) A method of producing a SIMOX wafer according to any one of items (1)-(3), wherein the oxide film is formed by an oxidation treatment using an oxygen or a steam, or by a CVD treatment using silane or dichlorosilane and an oxygen.

(5) A method of producing a SIMOX wafer according to any one of items (1)-(4), wherein the oxide film has a thickness of 5-100 nm.

(6) A method of producing a SIMOX wafer according to any one of items (1)-(5), wherein an outer periphery of the oxide film is removed by etching to improve a flow of electric charge from a contact pin at the oxygen ion implantation step.

According to the invention, the direct contact of the particles adhered onto the wafer with the silicon surface can be prevented effectively not only at the oxygen ion implantation step in SIMOX process but also at the high-temperature annealing step, and as a result, the occurrence of surface defect resulted from the particles can be largely reduced as compared with the conventional technique.

### DESCRIPTION OF THE DRAWINGS

FIG. 1 is a schematic view illustrating a behavior of particles in SIMOX process according to the conventional technique.
FIG. 2 is a schematic view illustrating a behavior of particles in SIMOX process according to the invention.
FIG. 3 is a schematic view illustrating the way of improving a flow of electric charges from a contact pin at an oxygen ion implantation step.
FIG. 4 is a flow chart of a typical SIMOX process according to the invention.

### DESCRIPTION OF THE PREFERRED EMBODIMENTS

The invention will be described concretely with reference to the accompanying drawings. At the oxygen ion implantation step in SIMOX process, particles are produced at least from a holder part and rotation system for the wafer, a beam line, a transportation system and the like. The particles are composed mainly of silicon, silicon oxide, carbon and the like used as a material for these members.

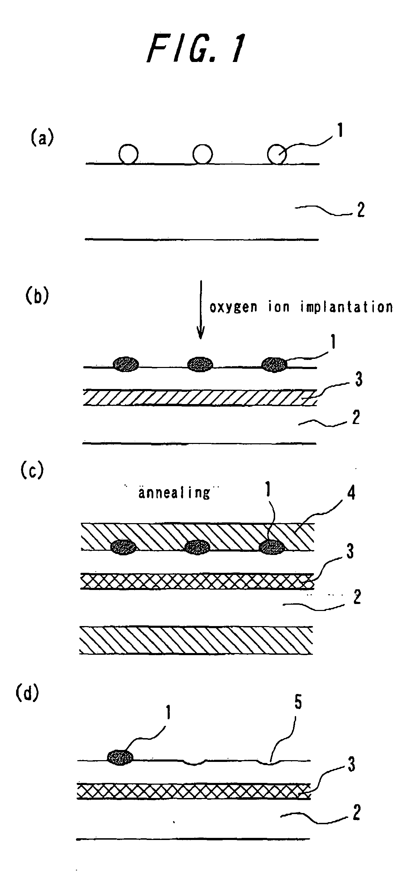

Heretofore, when particles 1 are adhered onto a bare silicon surface of a wafer 2 as shown in FIG. 1(a), they are baked onto the silicon surface by a temperature rise in the formation of BOX film 3 through an oxygen ion implantation as shown in FIG. 1(b), which is high in the possibility of causing particle defects in a final product. Also, even if the particles 1 baked on the silicon surface are removed together with an oxide film 4 formed in the annealing as shown in FIG. 1(c) by the etching of the oxide film 4, they are left as a bore trace 5 as shown in FIG. 1(d) to cause the surface defect.

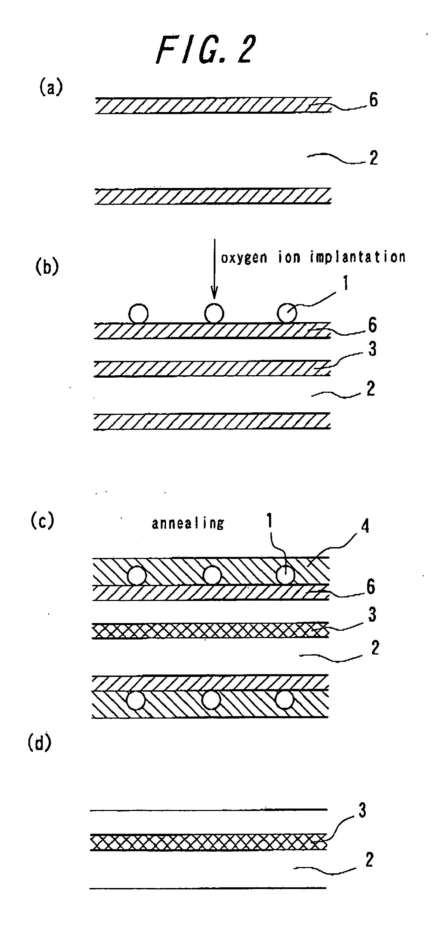

On the contrary, according to the invention, an oxide film (hereinafter referred to as a screen oxide for distinguishing from the oxide film 4 formed in the annealing) 6 is formed on a silicon surface prior to the oxygen ion implantation as shown in FIG. 2(a). When the oxygen ion is implanted through the screen oxide 6, even if the particles 1 are produced during the implantation, these particles 1 do not directly adhere onto the silicon surface but adhere onto the surface of the screen oxide 6 as shown in FIG. 2(b), so that the particles 1 do not bake on the silicon surface in the annealing as shown in FIG. 2(c), and hence the particles 1 are removed together with the screen oxide 6 by subjecting the screen oxide 6 together with the particles 1 to an etching with HF or the like after the implantation, and as a result, the silicon surface is kept at a bare state as shown in FIG. 2(d).

If the screen oxide is left up to the high-temperature annealing step without the complete removal after the oxygen ion implantation, it effectively serves as a protection film to the particles in the high-temperature annealing process. Even in the high-temperature annealing process, it is considered that the particles particularly adhered onto the bare silicon surface at an initial process stage not forming a surface oxide film are baked on the surface in the subsequent high-temperature annealing, which is high in the possibility of causing the surface defect in a final product. Moreover, all of the screen oxide and an oxide film formed in the annealing are finally removed, so that the particles adhered in the annealing can be effectively removed together with these oxide films.

The screen oxide is preferable to have a thickness of not less than 5 nm because the thickness is decreased by sputtering in the oxygen ion implantation. Although the thickness of the screen oxide can be thickened by increasing the implantation energy, it is desirable to be not more than 100 nm considering the actual implantation energy and subsequent annealing process.

Also, as a method of forming the screen oxide, there are considered a chemical oxide, a sol-gel method and the like, but a usual oxidation method or a method of forming an oxide film through CVD (chemical vapor deposition) process is advantageously adaptable from a viewpoint of the quality of the screen oxide.

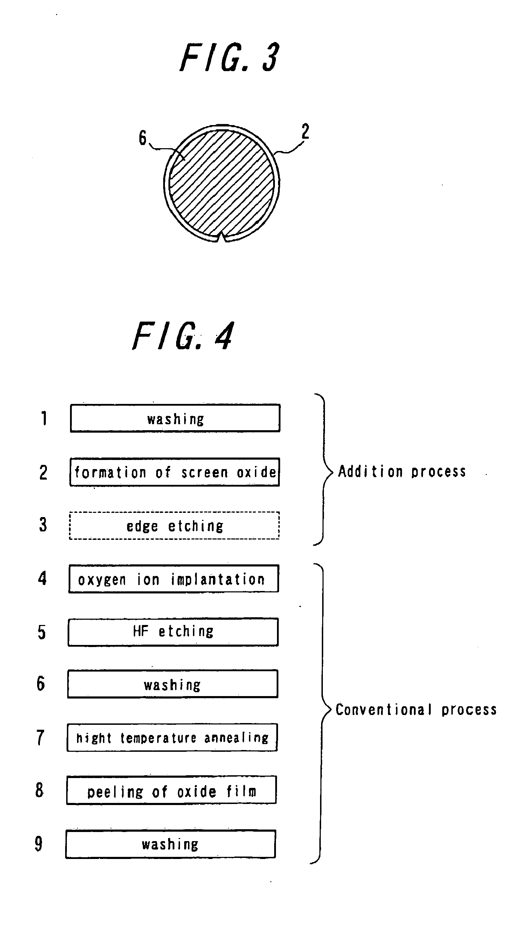

In case of forming the screen oxide, the silicon surface is covered with an insulating film, so that there is feared a problem on a charge-up in the ion implantation. In this case, a portion of holding the wafer with a holder corresponds to an outer peripheral edge portion of the wafer, so that it is desirable that only the insulating film is removed from the outer peripheral edge portion by a distance of several mm by etching this portion with a solution of HF or the like. That is, as shown in FIG. 3, it is preferable that the screen oxide 6 is removed from the outer periphery by only several mm over a full periphery of the wafer 2. In this way, electric charges flow effectively from a contact pin at the oxygen ion implantation step, so that the problem on the charge-up in the ion implantation is overcome.

For reference, a typical flow chart of SIMOX process according to the invention is shown in FIG. 4.

### (Examples)

The invention is described with reference to a case of applying to SIMOX process through MLD method.

The oxygen ion implantation is first carried out under conditions of an acceleration energy: 170 keV, a dose: 2.5x10¹⁷ cm⁻² and a substrate temperature: 400°C and thereafter the ion implantation is carried out at room temperature and a dose of 2.5x10¹⁵ cm⁻². Then, ITOX process is conducted at 1320°C for 10 hours and the annealing is carried out in an Ar atmosphere (oxygen content: 4%) at 1350°C for 10-20 hours. With respect to the thus obtained wafer is examined the particle defect to obtain a result as shown in Table 1.

In Table 1, Nos. 1-5 are comparative examples according to the conventional method, and Nos. 6-10 are invention examples in which a screen oxide is formed on a surface of a wafer prior to the oxygen ion implantation according to the invention and then the ion implantation is conducted through the screen oxide. In a part of the invention examples, a part or a whole of the screen oxide is removed by etching after the ion implantation. Also, the thickness of the screen oxide and the removing ratio of the screen oxide after the oxygen ion implantation are shown in Table 1.

Moreover, the particle defect is evaluated the number of particles having a particle size of not less than 0.16 µm (>0.16 um) or not less than 0.5 µm (>0.5 um) on the surface of the wafer through SP1.

**Table 1**

| No. | Thickness of screen oxide (nm) | Removing ratio of screen oxide after oxygen ion implantation (%) | >0.16 um (/wfr) | >0.5 um (/wfr) | Remarks |
|---|---|---|---|---|---|
| 1 | - | - | 76 | 24 | Comparative Example 1 |
| 2 | - | - | 146 | 30 | Comparative Example 2 |
| 3 | - | - | 130 | 34 | Comparative Example 3 |
| 4 | - | - | 90 | 20 | Comparative Example 4 |
| 5 | - | - | 180 | 21 | Comparative Example 5 |
| 6 | 50 | 100 | 32 | 5 | Invention Example 1 |
| 7 | 60 | 50 | 19 | 8 | Invention Example 2 |
| 8 | 70 | 35 | 13 | 3 | Invention Example 3 |
| 9 | 80 | 30 | 24 | 4 | Invention Example 4 |
| 10 | 100 | 25 | 27 | 7 | Invention Example 5 |
| 11 | 100 | 25 | 20 | 5 | Invention Example 6 |

As seen from Table 1, the particle level can be largely reduced by using SIMOX process according to the invention.

Moreover, No. 11 in Table 1 is an example wherein the outer periphery (3 mm) of the screen oxide is removed by etching as shown in FIG. 3 to improve the flow of electric charges from a contact pin at the oxygen ion implantation step. In this case, there is caused no problem on the charge-up in the ion implantation.

Further, with respect to the above invention examples and comparative examples, there are examined densities of HF defect and divot defect as a typical defect of SOI wafer. The HF defect is evaluated by the occurrence number per cm² and the divot defect is evaluated by the number of pits arriving at the buried oxide film as observed by means of SEM. The results are shown in Table 2.

**Table 2**

| No. | HF defect (cm⁻²) | Divot (/wfr) |
|---|---|---|
| 1 | 0.03 | 20 |
| 2 | 0.05 | 30 |
| 3 | 0.04 | 21 |
| 4 | 0.03 | 15 |
| 5 | 0.05 | 19 |
| 6 | 0.015 | 5 |
| 7 | 0.01 | 3 |
| 8 | 0.005 | 1 |
| 9 | 0.01 | 2 |
| 10 | 0.01 | 4 |
| 11 | 0.01 | 2 |

As seen from Table 2, the defects inherent to SOI can be largely decreased according to the invention.

Although the above examples are mainly explained with respect to the case of applying the invention to SIMOX process through MLD method, it is confirmed that similar effects are obtained even when the invention is applied to SIMOX process through the high-dose SIMOX method and low-dose SIMOX method.

As mentioned above, the invention develops the effect that the final particle level on SOI surface is largely improved. Also, when the high-temperature annealing is carried out at a state of existing the screen oxide on the rear face of the wafer, the bare rear face is not directly contacted with the wafer holder in the high-temperature annealing, so that there is obtained an additional effect that the occurrence of flaw feared on the rear face of the wafer is largely decreased.

## Claims

1. A method of producing a SIMOX wafer comprising an oxygen ion implantation step and a high-temperature annealing step, wherein an oxide film is formed on a surface of a wafer prior to the oxygen ion implantation and then the oxygen ion implantation is conducted through the oxide film.

2. A method of producing a SIMOX wafer according to claim 1, wherein a part or a whole of the oxide film is etched to remove particles adhered onto the oxide film after the oxygen ion implantation.

3. A method of producing a SIMOX wafer according to claim 1, wherein at least a part of the oxide film after the oxygen ion implantation is utilized as a protection film at the subsequent high-temperature annealing step without complete removal.

4. A method of producing a SIMOX wafer according to any one of claims 1-3, wherein the oxide film is formed by an oxidation treatment using an oxygen or a steam, or by a CVD treatment using silane or dichlorosilane and an oxygen.

5. A method of producing a SIMOX wafer according to any one of claims 1-4, wherein the oxide film has a thickness of 5-100 nm.

6. A method of producing a SIMOX wafer according to any one of claims 1-5, wherein an outer periphery of the oxide film is removed by etching to improve a flow of electric charge from a contact pin at the oxygen ion implantation step.
